# EUROPEAN PATENT APPLICATION

(11) **EP 2 278 629 A2**
(43) Date of publication of application: **26.01.2011**
(21) Application number: 10251305.8
(22) Date of filing: 22.07.2010
(51) Int. Cl.: H01L 31/052

(54) **Reflective photovoltaic concentrator**

(30) Priority: 23.07.2009 US 507988
(71) Applicant: Hamilton Sundstrand Corporation, Windsor Locks, CT 06096-1010 (US)
(72) Inventor: Lu, Cheng-Yi, West Hills California 91307 (US)
(74) Representative: Tomlinson, Kerry John

(57) **Abstract**

A reflective concentrated photovoltaic (CPV) array (200) includes a plurality of Fresnel reflectors (202) connected to and extending outward from a support structure (204), which direct light onto a CPV panel (208). The CPV panel is at least thermally connected to the support structure via a heat pipe radiator (206).

## Description

### BACKGROUND OF THE INVENTION

The present disclosure is directed to a concentrated photovoltaic array, and more specifically to such an array providing power to a satellite.

Photovoltaic arrays (also known as Solar Power Generators) are often used where typical stored energy solutions, such as batteries, are unacceptable, and where a device needing power will have access to a steady source of light. As an example, a terrestrial solar power farm utilizes photovoltaic arrays to generate power for supplying power to the power grid. The atmosphere surrounding the arrays typically provides adequate heat convection to remove excess heat and prevent overheating, such that thermal management is not an issue.

### SUMMARY OF THE INVENTION

An exemplary reflective concentrated photovoltaic array includes a support structure with multiple primary reflectors connected to it. The primary reflectors extend outward from the center structure, and reflect light onto a concentrated photo voltaic array. The concentrated photovoltaic array is connected to the center structure via a heat pipe radiator.

An exemplary embodiment includes a satellite with at least one of the above described concentrated photovoltaic arrays connected to a main body. The concentrated photovoltaic array is used to generate power for the satellite's operations, and uses the described heat pipe radiator to remove heat from the solar panels.

These and other features of the present invention can be best understood from the following specification and drawings, the following of which is a brief description.

### BRIEF DESCRIPTION OF THE DRAWINGS

Figure 1 illustrates a satellite capable of receiving power from a plurality of attached photovoltaic arrays.
Figure 2 illustrates an example photovoltaic array.
Figure 3 illustrates an example photovoltaic array.
Figure 4 illustrates an example photovoltaic array with an additional secondary reflector.

### DETAILED DESCRIPTION OF THE PREFERRED EMBODIMENT

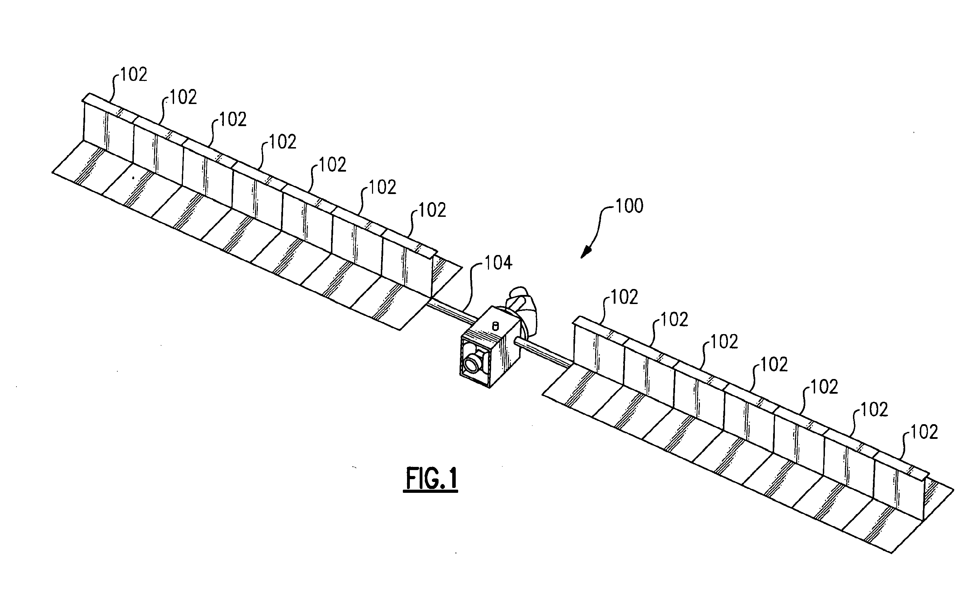

Figure 1 illustrates a satellite 100 having solar panel assemblies 102 to generate electric power to operate the satellite 100. The solar panel assemblies 102 begin in a folded position to conserve space on the launch vehicle. When the satellite 100 is deployed, the solar panels 102 unfold and extend outward from the satellite 100, such that the panels 102 are oriented toward a light source, typically the sun, in order to receive the light required for photovoltaic power generation. Each of the solar panel assemblies 102 is independently capable of generating power, and is connected within the satellite 100 through a support structure 104, which may also be referred to as a center structure.

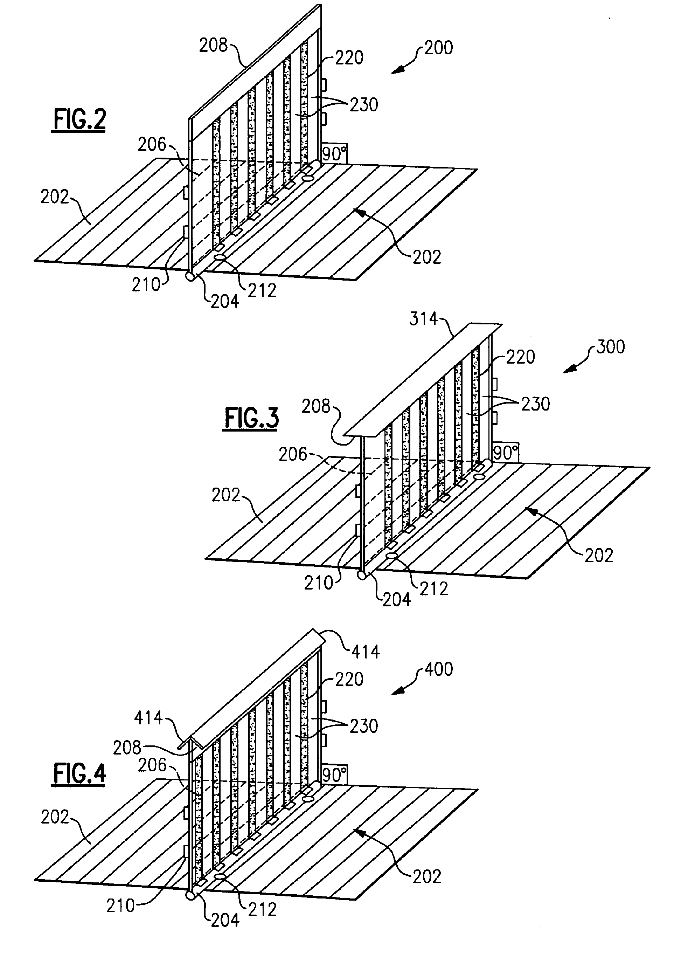

Figure 2 illustrates an example solar panel assembly 200 which can be used as solar panel assembly 102 in Figure 1. The solar panel assembly 200 includes two primary reflectors 202 connected to the support structure 204 via hinges 212. Also connected to the support structure 204 is a heat pipe radiator 206. The heat pipe radiator 206 is connected to a concentrated photovoltaic array 208 on an end opposite the support structure 204. Additionally connected to the heat pipe radiator 206 are hinges 210. The hinges 210 operate to connect the solar panel assembly 200 to other solar panel assemblies in a folded configuration during deployment, and allow the solar panel assemblies 102 to fully unfold during the satellite 100 deployment.

While the satellite 100 is folded for transport, the primary reflectors 202 are substantially parallel to and adjacent to the heat pipe radiator 206. Once the satellite 100 is deployed, the primary reflectors 202 rotate away from the heat pipe radiator 206 to a desired angle. The desired angle can be any angle which allows the primary reflector 202 to direct reflected light onto the concentrated photovoltaic array 208. By way of example, the primary reflectors 202 can be at a 90° angle relative to the heat pipe radiator 206. When light reflects off of the primary reflectors 202 and onto the concentrated photovoltaic array 208, the light is converted into electrical energy using known photovoltaic energy generation techniques. The energy can then be used to power the satellite 100. The photovoltaic technique produces excess heat as a byproduct of power generation.

Figure 3 illustrates a modified concentrated photovoltaic assembly 300 which can be used as a solar assembly 102 in Figure 1, with like numerals indicating like elements. The example concentrated photovoltaic assembly of Figure 3 additionally includes a top plane 314 at angles to the heat pipe radiator 206. The top plane 314 has a concentrated photovoltaic array 208 facing the primary reflector 202. On the opposite side of top plane 314 there is heat sink thermally coupled with heat pipe radiator 206. In this configuration the concentrated photovoltaic array collects more solar energy for power conversion than in the example of Figure 2. This gain results from reduction of reflection loss on the concentrated photovoltaic array 208 compared to the example of Figure 2. In this example, as in the first example, the concentrated photovoltaic array 208 generates large amounts of excess heat as a byproduct of the power generation.

Figure 4 illustrates another modified concentrated photovoltaic assembly 400 which can be used as a solar assembly 102 in Figure 1, with like numerals indicating like elements. The example concentrated photovoltaic assembly of Figure 4 additionally includes a secondary reflector 414, which is not utilized in the example of Figure 2. The secondary reflector 414 collects light reflected from the primary reflectors 202, and redirects the light to the concentrated photovoltaic array 208. More light can be collected using the secondary reflectors than in the example of Figure 2, as the primary reflectors 202 have a wider and more direct area onto which they can focus the light, thereby allowing more light to be captured. In this example, as in the first example, the concentrated photovoltaic array 208 generates large amounts of excess heat as a byproduct of the power generation.

The excess heat rejects from the front and the back of the photovoltaic array 208. In terrestrial applications, the surrounding atmosphere absorbs the heat via heat convection, thereby preventing or limiting any overheating. The rate at which the waste heat can be rejected from the concentrated photovoltaic array in any environment is related to the exposed surface area contacting a fluid, into which the excess heat is transferred. In a terrestrial embodiment the fluid would typically be air. Environmental conditions can prevent the excess heat from being adequately rejected away from the CPV. By way of example, a lack of an atmosphere, such as in space, will reduce the rate at which the excess heat can be radiated off of the exposed surface area.

To remove heat, the solar panel array 100, 200, 300 or 400 may include a heat pipe radiator 206. The heat pipe radiator 206 includes heat pipes 220 which connect the concentrated photovoltaic array 208 to the support structure 104. The heat pipe radiator also includes radiating fins 230 mounted on two sides of heat pipes 220, which provide structure continuation and heat radiation surface areas. The radiating fins illustrated in Figure 4 can be utilized in any of the described examples. The heat pipes 220 are connected to the concentrated photovoltaic array 208 and the support structure 104 to transmit heat away from the concentrated photovoltaic array 208. The radiating fins 230 provide a larger exposed surface area for the heat to be radiated from, thereby increasing the rate at which heat is radiated into the surrounding environment. The use of a heat pipe radiator provides further benefits in that the excess heat is drawn directly away from the CPV rather than relying on radiation across.

A heat pipe 220 is a sealed pipe or tube made of a material with high thermal conductivity, such as copper or aluminum. All air is removed from the empty heat pipe and the pipe is partially filled with a working fluid, (or coolant), chosen to match the operating temperature. Some example fluids are water, ethanol, acetone, sodium, or mercury. The partial vacuum inside the tube is near or below the vapor pressure of the fluid, and consequently a portion of the fluid will be in the liquid phase and another portion will be in the gas phase. The heat pipe 220 transfers the heat from a hot end, connected to the concentrated photovoltaic array 208 through a thermally conductive connection, by heating up the liquid portion of the coolant resulting in phase change to gas phase. The heated gas then condenses at the cold end of the heat pipe, releasing the heat into radiator surface areas, which then release the heat into the surrounding environment. The condensed coolant can be transported back to the hot end through wicks inside the heat pipe via capillary force.

The primary reflector 202 is a flat surface Fresnel reflector. It is made of a plurality of Fresnel grooves and each groove has a specific slope of inclination. When illuminated by solar rays it concentrates incoming solar rays to the concentrated photovoltaic array 208 or to the secondary reflector 414.

While the above examples are directed toward applications in space, the disclosed concepts may provide significant benefits in any environment where more rapid heat radiation is desired.

Although several examples of this invention have been disclosed, a worker of ordinary skill in this art would recognize that certain modifications would come within the scope of this invention. For that reason, the following claims should be studied to determine the true scope and content of this invention.

## Claims

1. A reflective concentrated photovoltaic (CPV) array (200,300,400) comprising:
a support structure (204);
a CPV panel (208) having a light-collecting surface;
a heat pipe radiator (206) at least thermally connecting said CPV panel to said support structure; and
a plurality of primary reflectors (202) connected to, and extending outward from said support structure, said plurality of primary reflectors having a reflective surface oriented to reflect light onto said light-collecting surface.

2. The reflective CPV array of claim 1, wherein said CPV panel (208) is further integrated with the heat pipe radiator (206) for structural support and waste heat transfer.

3. The reflective CPV array of claim 1 or 2, further comprising a top plane (314) with the CPV panel mounted on the primary reflector facing side.

4. The reflective CPV array of claim 1, 2, or 3, wherein the primary reflector (202) comprises a plurality of Fresnel grooves, each groove having a slope of inclination to concentrate incoming solar rays to the CPV panel.

5. The reflective CPV array of claim 1 or 2, further comprising a secondary reflector (414) oriented to receive light reflected from said plurality of primary reflectors and reflect said light toward said CPV panel; preferably wherein the primary reflector (202) comprises a plurality of Fresnel grooves, each groove having a slope of inclination to concentrate incoming solar rays to the secondary reflector.

6. The reflective CPV array of any preceding claim, further comprising at least one hinge (212) connecting each of said plurality of primary reflectors to said support structure.

7. The reflective CPV array of any preceding claim, wherein said heat pipe radiator comprises at least one connector (210) for connecting to additional reflective CPV arrays; preferably wherein said connector is a hinge (210).

8. The reflective CPV array of any preceding claim, wherein the heat pipe radiator comprises a plurality of heat pipes (220) and a radiating fin surface (230) connecting each of said heat pipes.

9. The reflective CPV array of claim 8, wherein each of said heat pipes is a thermal conductor and is connected to said CPV panel via a thermal conductor.

10. The reflective CPV array of claim 8 or 9, wherein each of said heat pipes is connected to said support structure.

11. The reflective CPV array of claim 10, additionally comprising a heat sink thermally connected to said heat pipe radiator; preferably wherein said heat sink comprises a fin shaped heat sink for radiating heat.

12. A satellite (100) comprising;
a main body;
a support structure (104) extending from said main body;
at least one solar panel assembly (102) connected to said support structure and electrically coupled to said main body, such that power generated in the solar panel is transmitted to the main body;
the at least one solar panel assembly having a concentrated photovoltaic array (CPV) panel (208), a heat pipe radiator (206), and a plurality of primary reflectors (202) connected to and extending outward from said support structure, each of said plurality of primary reflectors having a reflective surface oriented towards said CPV panel for reflecting light onto said CPV panel; and
said heat pipe radiator connecting said CPV panel to said support structure.

13. The satellite of claim 12, wherein said heat pipe radiator comprises a plurality of heat pipes (220) connected to said CPV panel on a first end via a thermal conductor, and connected to said support structure on a second end, opposite said first end.

14. A method of removing heat from a reflective concentrated photovoltaic (CPV) array comprising the steps of:
transferring heat from a CPV (208) panel to a heat pipe (230); and
directing the heat from said CPV panel and toward a heat pipe radiator (206).

15. The method of claim 14, further comprising radiating the heat into a surrounding environment.
